# EUROPÄISCHE PATENTANMELDUNG

(11) **EP 2 388 920 A1**
(43) Veröffentlichungstag der Anmeldung: **23.11.2011**
(21) Anmeldenummer: 10163509.2
(22) Anmeldetag: 21.05.2010
(51) Int. Cl.: H03K 17/955, H03K 17/96

(54) **Kapazitiver Schalter**

(71) Anmelder: RAFI GmbH & Co. KG, 88276 Berg (DE)
(72) Erfinder: Bulach, Eric, 88074 Meckenbeuren (DE); Sitnikov, Eugen, 88213 Ravensburg (DE)
(74) Vertreter: Engelhardt & Engelhardt

(57) **Zusammenfassung**

Bei einem kapazitiven Schalter (1) zur Erzeugung eines elektrischen Schaltsignals, bestehend aus einer Trägerplatte (2), insbesondere Leiterplatte, auf deren Oberfläche (9) eine ein Kapazitätsfeld (5) erzeugende Metallschicht (3) aufgebracht ist, und aus einer dünnwandigen Abdeckplatte (11), sollen diese in Bedienoberflächen von elektrischen Geräten einsetzbar sein, die in sterilen Umgebungen, beispielsweise in Operationsräumen von Krankenhäusern oder in der Lebensmittelindustrie verwendet sind, ohne dass durch die notwendige Säuberungsmaßnahme die Abdeckplatte (11) beschädigt ist.

Dies wird dadurch gelöst, dass die Abdeckplatte (11) ganz oder teilweise aus Metall besteht oder dass auf der der Trägerplatte (2) zugewandten Oberfläche (17) der Abdeckplatte (11) ein Metallüberzug (12) aufgebracht ist, und dass die Abdeckplatte (11) mit der Metallschicht (3) das Kapazitätsfeld bildet, und dass zwischen der Metallschicht (3) und der Abdeckplatte (11) ein Abstand halter (15) angeordnet ist, durch den die Metallschicht (3) und die Abdeckplatte (11) bzw. dem Metallüberzug (12) galvanisch voneinander getrennt sind.

## Beschreibung

Die Erfindung bezieht sich auf einen kapazitiven Schalter zur Erzeugung eines elektrischen Schaltsignals nach dem Oberbegriff von Patentanspruch 1.

Solche kapazitiven Schalter sind in einer Vielzahl von Anwendungen einsetzbar. Das von der Metallschicht durch eine induzierte Spannung erzeugte Kapazitätsfeld auf der Trägerplatte des Schalters ist dabei in Richtung einer Bedienoberfläche gerichtet. Sobald das Kapazitätsfeld, beispielsweise durch das Eindringen eines menschlichen Fingers, gestört ist, verändert sich dessen Wert. Durch einen zu der Metallschicht benachbart angeordneten integrierten Schaltkreis sind diese Veränderungen des Kapazitätsfeldes permanent messbar, so dass durch einen elektrisch mit dem integrierten Schaltkreis gekoppelten Mikrakontroller ein elektrisches Schaltsignal erzeugbar ist, wenn das Kapazitätsfeld der Metallschicht einen voreingestellten Grenzwert unter- oder überschreitet.

Die Abdeckplatten solcher Schalter bestehen üblicherweise aus Glas oder Kunststoff, dessen Wandstärke derart bemessen ist, dass eine Kapazitätsfeldänderung eintritt, wenn ein menschlicher Finger, der als Kondensatorplatte anzusehen ist, in das von der Metallschicht erzeugte Kapazitätsfetd eindringt.

Die derart konstruierten Schalter sind nachteiligerweise in sterilen Umgebungen nicht einsetzbar, denn die aus Glas oder Kunststoff bestehende Abdeckplatte kann nicht steril gehalten werden, da dadurch die Abdeckplatte zerkratzt oder zerstört wird oder mittels aggressiver Putzmittel entsprechend gesäubert wird.

Der Erfindung liegt daher die Aufgabe zugrunde, einen kapazitiven Schalter der eingangs genannten Gattung derart konstruktiv weiterzubilden, dass dieser in Bedienoberflächen von elektrischen Geräten einsetzbar ist, die in sterilen Umgebungen, beispielsweise in Operationsräumen von Krankenhäusern oder in der Lebensmittelindustrie verwendet sind, einsetzbar sind, ohne dass durch die notwendige Säuberungsmaßnahme die Abdeckplatte beschädigt ist.

Diese Aufgabe wird erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die Abdeckplatte ganz oder zumindest teilweise aus Metall besteht oder dass die Oberfläche der Abdeckplatte die der Trägerplatte zugewandt ist, mit einer Metallschicht überzogen ist, ist zum Einen gewährleistet, dass die Außenseite der Abdeckplatte steril gehalten werden kann, denn diese kann mit aggressiven Reinigungsmitteln, Heißwasserstrahlen und dergleichen gesäubert werden, ohne dass die Struktur der Abdeckplatte beschädigt ist. Zum Anderen dient die Metall-Abdeckplatte oder der metallische Überzug auf der der Trägerplatte zugewandten Oberfläche der Abdeckplatte dazu, zusammen mit der Metallschicht auf der Trägerplatte ein Kapazitätsfeld zu erzeugen.

Das Kapazitätsfeld kann nicht mehr von außen durch das Eindringen eines menschlichen Fingers verändert werden. Die Veränderung des Kapazitätsfeldes ist vielmehr dadurch zu bewerkstelligen, dass der Abstand zwischen der Abdeckplatte und der Metallschicht zu verändern ist. Die Metallschicht bildet demnach eine feststehende erste Kondensatorplatte; wohingegen die Abdeckplatte bzw. der metallische Überzug der Abdeckplatte, die zweite Kondensatorplatte darstellt. Wenn daher der Abstand der Kondensatorplatten variiert ist, verändert sich der Wert des Kapazitätsfeldes in Abhängigkeit von dem Abstand zwischen den beiden Kondensatorplatten.

Folglich ist durch die Durchbiegung der Abdeckplatte eine solche Abstandsveränderung erreicht, so dass ein elektrisches Schaltsignal generierbar ist. Dieses Schaltsignal kann zur Steuerung eines elektrischen Gerätes eingesetzt sein.

Derartige Schalter können ein gemeinsames Schaltfeld eines elektrischen Gerätes bilden. Die Bediensymbole sind beispielsweise mittels Laserstrahlen oder sonstigen chemischen oder mechanischen Gravurmöglichkeiten in die Oberfläche der Abdeckplatte eingebracht, so dass der Benutzer das jeweilige Bedienfeld einem bestimmten Steuerungssignal zuordnen kann.

Um einen Druckausgleich zwischen der Metallschicht und der Abdeckplatte zu erreichen, denn der von der Abdeckplatte, der Metallschicht und dem Abstandshalter begrenzten Raum, in dem das Kapazitätsfeld gebildet ist, ist luftdicht verschlossen, so dass dieses gegebenenfalls zu Beschädigungen des Schalters führt, wenn dieser beispielsweise in einem Flugzeug einer Druckerhöhung ausgesetzt ist, ist zu diesem Zweck eine Durchgangsöffnung in die Trägerplatte und die Metallschicht und/oder in die Abdeckplatte eingearbeitet.

Es ist besonders vorteilhaft, wenn in dem von der Abdeckplatte, dem Abstandshalter und der Metallschicht begrenzten Raum ein gasförmiges Medium, das in einem elastisch verformbaren Ballon eingefüllt ist, eingesetzt ist. Durch den im Inneren des Ballons herrschenden Innendruck ist nämlich auf die Abdeckplatte eine Kraft, die nach außen ausgerichtet ist, aufgebracht, durch die die elastisch verformbare Abdeckplatte dom- oder kuppelförmig nach außen ausgebeult ist. Dies ermöglicht nämlich die Bildung von Dreidimensionalen Strukturen auf der Oberfläche der Abdeckplatte, die als Bedienhilfen verwendet werden können.

In der Zeichnung sind fünf erfindungsgemäße Ausführungsbeispiele eines Schalters dargestellt, die nachfolgend näher erläutert sind. Im Einzelnen zeigt:

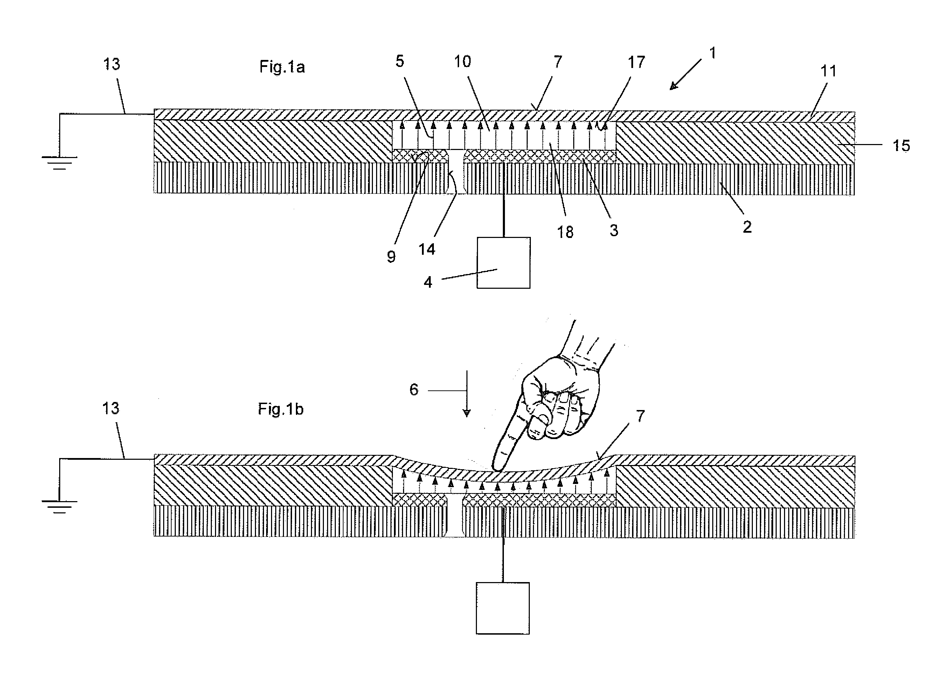

- Figur 1a: ein erstes Ausführungsbeispiel eines Schalters mit einer Leiterplatte, die als Trägerplatte für eine auf dieser aufgebrachten Metallschicht wirkt, und mit einer zu der Metallschicht beabstandet angeordneten Abdeckplatte aus Metall, die durch einen Abstandshalter von der Metall- schicht abgehoben ist und die mittels einer elektrischen Leitung geerdet ist, im Schnitt und im unbelasteten Zustand,
- Figur 1 b: den Schalter gemäß Figur 1 a im belasteten Zustand,
- Figur 2a: ein zweites Ausführungsbeispiel eines Schalters, mit einer Leiterplatte, die als Trägerplatte für eine auf dieser aufgebrachten Metallschicht wirkt, und mit einer zu der Metallschicht beabstandet angeordneten Abdeckplatte aus Metall, die durch einen Abstandshalter von der Metallschicht abgehoben ist, im Schnitt und im unbelasteten Zustand,
- Figur 2b: der Schalter gemäß Figur 2a im belasteten Zustand,
- Figur 3a: den Schalter gemäß Figur 1 oder 2a in Draufsicht als Bedienfeld für ein elektrisches Geräte,
- Figur 3b: den Schalter gemäß Figur 2a entlang der Schnittlinie IIIb - IIIb,
- Figur 4: ein drittes Ausführungsbeispiel eines Schalters, mit einer Leiterplatte, die als Trägerplatte für eine auf dieser aufgebrachten Metallschicht wirkt, und mit einer zu der Metallschicht beabstandet angeordneten Abdeckplatte aus Kunststoff, die durch einen Abstandshalter von der Metallschicht abgehoben ist, an der ein Überzug aus Metall angebracht ist, der mittels einer elektrischen Leitung geerdet ist, im Schnitt und im unbelasteten Zustand,
- Figur 5a: ein viertes Ausführungsbeispiel eines Schalters, mit einer Leiterplatte, die als Trägerplatte für eine auf dieser aufgebrachten Metallschicht dient, und mit einer zu der Metallschicht beabstandet angeordneten Abdeckplatte aus Metall, die durch einen Abstandshalter von der Metallschicht abgehoben ist und zwischen denen ein elastisch verformbares Kissen aus Silikon eingesetzt ist, im Schnitt und im unbelasteten Zustand,
- Figur 5b: den Schalter gemäß Figur 5a, im belasteten Zustand und
- Figur 6: ein fünftes Ausführungsbeispiel eines Schalters mit einem kapazitiven Touchpad, im Schnitt.

In den Figuren 1 a und 1 b ist ein kapazitiver Schalter 1 zu entnehmen, durch den bei dessen Betätigung ein elektrisches Schaltsignal genierbar sein soll. Der Schalter 1 besteht aus einer Trägerplatte 2, die als Leiterplatte ausgestaltet ist. Auf der Oberfläche 9 der Trägerplatte 2 ist eine Metallschicht 3 bereichsweise aufgebracht. Die Metallschicht 3 weist nicht dargestellte elektrische Anschlüsse auf, so dass an die Metallschicht 3 eine elektrische Spannung induzierbar ist, durch die ein Kapazitätsfeld 5 entsteht. Das Kapazitätsfeld 5 ist schematisch mittels der Pfeile dargestellt.

Die Metallschicht 3 ist demnach als eine erste Kondensatorplatte anzusehen. Die zweite Kondensatorplatte ist durch eine Abdeckplatte 11 aus Metall gebildet. Die Abdeckplatte 11 ist mittels eines Abstandshalters 15 von der Metallschicht 3 beabstandet, so dass zwischen der Metallschicht 3 der Abdeckplatte 11 und dem Abstandhalter 15 ein Raum 18 gebildet ist, in dem das Kapazitätsfeld 5 verläuft. Mittels einer elektrischen Leitung 13 ist die Abdeckplatte 11 geerdet.

In Figur 1b ist die Betätigung der Abdeckplatte 11 zu entnehmen. Durch eine manuell aufzubringende Kraft ist die Abdeckplatte 11 nämlich elastisch verformt, und zwar in Richtung auf die Metallschicht 3, so dass der Abstand zwischen der Metallschicht 3 und der Abdeckplatte 11 durch die Krafteinwirkung verringert ist. Diese Abstandsveränderung führt zu einer Kapazitätsfeldveränderung nach den bekannten physikalischen Gesetzmäßigkeiten. Mittels eines integrierten Schaltkreises 4, der elektrisch an die Metallschicht 3 gekoppelt ist, ist die Kapazitätsfeldveränderung ermittelbar. Der integrierte Schaltkreis 4 leitet diese elektrische Information beispielsweise an einen nicht dargestellten Mikroprozessor weiter, durch den anschließend ein entsprechendes Schaltsignal ausgelöst ist.

Da der Raum 18 durch die Metallschicht 3, die Abdeckplatte 11 und den Abstandhalter 15 luftdicht verschlossen ist, kann bei Druckerhöhungen, beispielsweise in einem Flugzeug, in dem Raum 18 ein Überdruck entstehen, durch den die Bauteile des Schalters 1 unnötig belastet sind und möglicherweise zerstört werden können. Um einen Überdruckabbau zu erreichen, ist in die Metallschicht 3 und die Trägerplatte 2 eine Durchgangsöffnung 14 eingearbeitet, um einen notwendigen Druckabbau sicherzustellen. Die Durchgangsöffnung 14 kann auch in der Abdeckplatte 11 vorgesehen sein.

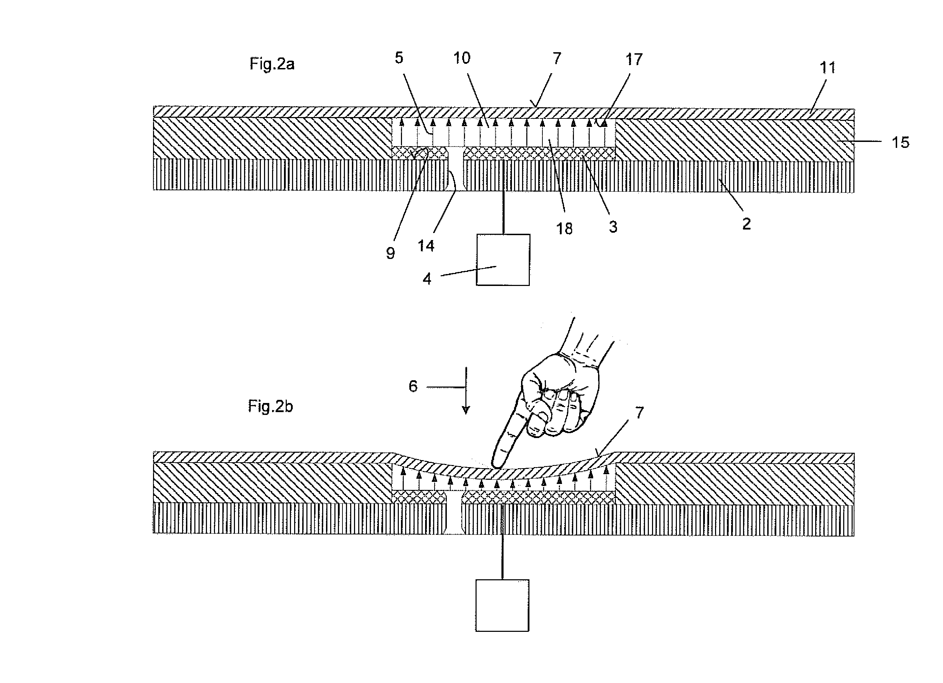

Der in den Figuren 2a und 2b abgebildete Schalter 1 entspricht in seinem konstruktiven Aufbau und in seiner Funktionsweise dem Schalter 1 nach den Figuren 1a und 1b. Lediglich die Abdeckplatte 11 ist nicht geerdet, da dies für die Betriebsweise des Schalters 1 nicht unbedingt erforderlich ist.

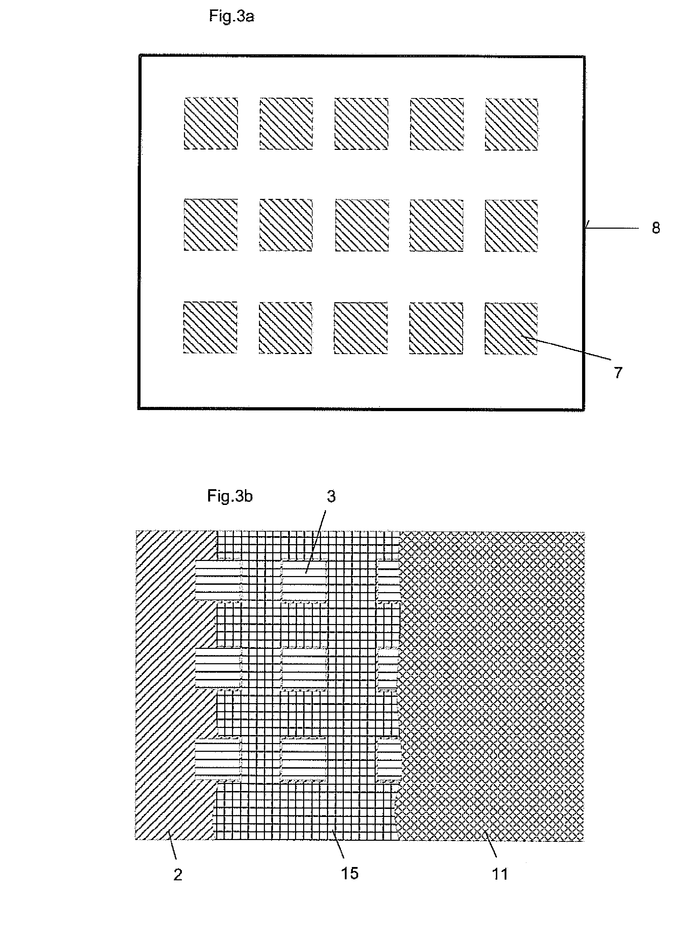

Insbesondere den Figuren 3a und 3b ist zu entnehmen, dass eine Vielzahl von Metallschichten 3 auf der Trägerplatte 2 zur Bildung eines gemeinsamen Schaltfeldes 7 vorgesehen sind. Das Schaltfeld 7 ist in einem Gehäuse 8 integriert und dient zur elektrischen Steuerung eines Gerätes, beispielsweise eines medizintechnischen Apparates oder einer Vorrichtung, die in der Lebensmittelindustrie, insbesondere in sterilen Räumen, zu verwenden ist. Die das Schaltfeld 7 nach außen verschließende Abdeckplatte 11 kann dabei sowohl aus Metall oder als Kunststoffplatte, auf der ein Überzug 12 aus Metall angebracht ist, bestehen. Darüber hinaus kann die Abdeckplatte 11 aus Metall bzw. der Überzug 12 aus Metall geerdet oder nicht geerdet sein.

Die Abdeckplatte 11 kann nämlich ohne weiteres mittels aggressiven Reinigungsmitteln gesäubert werden, ohne dass die Oberfläche der Abdeckplatte 11 beschädigt ist. Folglich kann die Abdeckplatte 11 steril gehalten werden, so dass das elektrische Gerät mit einem solchen Bedienfeld 7 in sterilen Umgebungen einsetzbar ist.

Zur Vereinfachung der Bediensymbolik ist in die Abdeckplatte 11 mittels mechanisch oder chemisch hergestellter Gravuren die entsprechende Information eingeätzt oder eingeritzt, so dass der Benutzer jedes der Schaltfelder 7 einer bestimmten Schaltfunktion zuordnen kann.

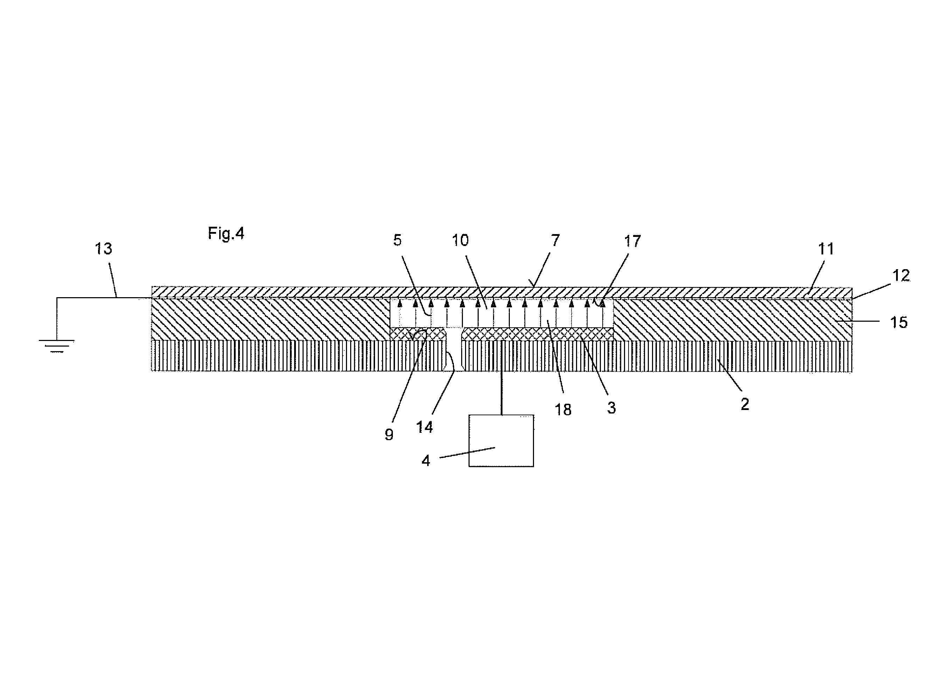

In Figur 4 ist eine Abdeckplatte 11 aus Kunststoff, beispielsweise Plexiglas oder dgl., gezeigt, auf deren der Trägerplatte 2 zugewandten Oberfläche 17 ein Metallüberzug 12 aufgebracht ist. Der Metallüberzug 12 ist mittels der elektrischen Leitung 13 geerdet; das Kapazitätsfeld 5 verläuft zwischen der Metallschicht 3 und dem Metallüberzug 12. Indem der Abstand zwischen dem Metallüberzug 12 und der Metallschicht 3 verkleinert ist, verändert sich das Kapazitätsfeld 5, so dass diese elektrische Information über den integrierten Schaltkreis 4 an eine elektrische Auswerteeinheit weitergeleitet werden kann.

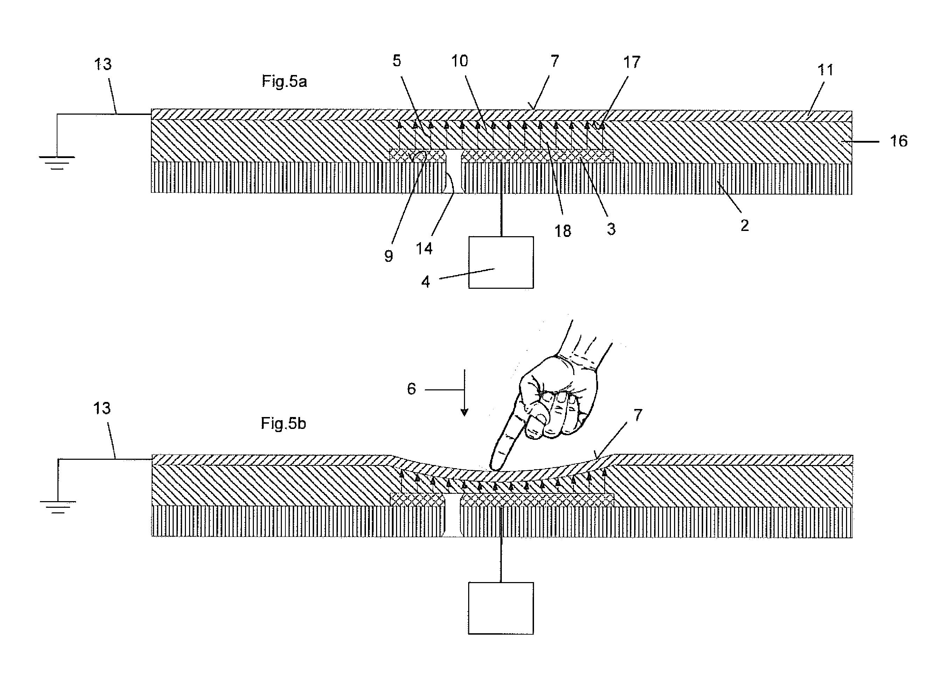

In den Figuren 5a und 5b ist gezeigt, dass in den Raum 18 ein elastisch verformbares Silikonkissen 16 eingesetzt ist, das zum Einen die Bildung des Kapazitätsfeldes 5 nicht behindert und zum Anderen bei einer manuellen Krafteinwirkung der Verformung der Abdeckplatte 11, die aus Metall oder als Kunststoffplatte mit einem Überzug aus Metall besteht, insoweit nicht entgegenwirkt, dass diese nicht in Richtung der Metallschicht 3 verformt werden kann, um eine Kapazitätsfeldveränderung zu erzeugen. Gleichwohl übt das Silikonkissen 18 eine Gegenkraft auf die Abdeckplatte 11 aus, durch die das taktile Schaltgefühl der Abdeckplatte 11 bzw. des Schalters 1 beeinflussbar ist.

Es ist auch vorstellbar, das Silikonkissen 16 bereichsweise kuppel- oder domförmig auszugestalten, so dass durch diese dreidimensionale Formgebung des Silikonkissens 16 eine dreidimensionale Struktur auf der Oberfläche der Abdeckplatte 11 geschaffen ist. Solche dreidimensionalen Strukturen sind als Bedienhilfen in dunklen Räumlichkeiten oder für sehbehinderte Menschen äußerst geeignet. Die Abdeckplatte 11 ist dabei elastisch verformbar ausgesfaltet. Diese kann beispielsweise mittels einer Aluminiumfolie erreicht sein.

Darüber hinaus ist es möglich, in den Raum 18 ein mit einem Medium 10 befüllten Ballon ortsfest einzusetzen. Der Ballon übt eine von innen nach außen verlaufende Kraft auf die Abdeckplatte 11 auf, so dass zum Einen das taktile Schaltgefühl des Schalters 11 durch den mit dem gasförmigen Medium 10 gefüllten Ballon beeinflusst ist und zum Anderen die Abdeckplatte 11 nach außen ausgebeult ist, indem nämlich bereichsweise eine dünnwandigere Ausgestaltung der Abdeckplatte 11 vorgesehen ist, die durch den in den Ballon herrschenden Innendruck ausgebeult ist.

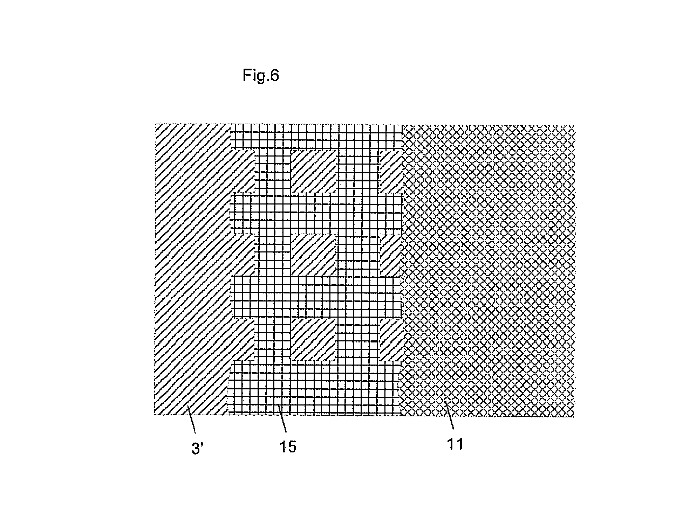

In Figur 6 ist der Schalter 1 derart ausgestaltet, dass dieser aus einem kapazitiven Touchpad 3' besteht. Die Abdeckplatte 11 ist aus Metall gefertigt. Auf die Trägerplatte 2 ist der Abstandhalter 15 mit den entsprechenden Aussparungen angeordnet, die fluchtend zu den Schaltfeldern des Touchpads 3' verlaufen. Die Abdeckplatte 11 aus Metall kapselt das Touchpad 3' und den Abstandhalter 15.

Sobald die Abdeckplatte 11 im Bereich der Aussparungen mit einer Kraft beaufschlagt ist, biegt sich die Abdeckplatte 11 in Richtung des Touchpads 3' durch, so dass die Kapazitätsfeldveränderung eintritt, die durch eine entsprechende Softwaretechnologie messbar und in elektrische Schaltsignale umwandelbar ist.

## Patentansprüche

1. Kapazitiver Schalter (1) zur Erzeugung eines elektrischen Schaltsignal, bestehend aus einer Trägerplatte (2), insbesondere Leiterplatte, auf deren Oberfläche (9) eine ein Kapazitätsfeld (5) erzeugende Metallschicht (3) aufgebracht ist, und aus einer dünnwandigen Abdeckplatte (11),
**dadurch gekennzeichnet,**
**dass** die Abdeckplatte (11) ganz oder teilweise aus Metall besteht oder dass auf der der Trägerplatte (2) zugewandten Oberfläche (17) der Abdeckplatte (11) ein Metallüberzug (12) aufgebracht ist, und dass die Abdeckplatte (11) mit der Metallschicht (3) das Kapazitätsteld bildet, und dass zwischen der Metallschicht (3) und der Abdeckplatte (11) ein Abstandhalter (15) angeordnet ist, durch den die Metallschicht (3) und die Abdeckplatte (11) bzw. dem Metallüberzug (12) galvanisch voneinander getrennt sind.

2. Schalter nach Anspruch 1,
**dadurch gekennzeichnet,**
**dass** in die Trägerplatte (2) und die Metallschicht (3) und/oder in die Abdeckplatte (11) bzw. den Metallüberzug (12) mindestens eine Durchgangsöffnung (14) eingearbeitet ist.

3. Schalter nach Anspruch 1 oder 2,
**dadurch gekennzeichnet,**
**dass** die metallische Abdeckplatte (11) oder der auf der Abdeckplatte (11) aufgebrachte Metallüberzug (12) mittels einer elektrischen Leitung (13) geerdet ist.

4. Schalter nach einem der vorgenannten Ansprüche,
**dadurch gekennzeichnet,**
**dass** zwischen der Abdeckplatte (11) und der Metallschicht (3) ein gasförmiges, flüssiges oder elastisch verformbares Medium (10, 10', 16) vorgesehen ist.

5. Schalter nach Anspruch 4,
**dadurch gekennzeichnet,**
**dass** das gasförmige Medium (10) in einen Ballon eingefüllt ist, und dass der Ballon zwischen der Abdeckplatte (11) und der Metallschicht (3) ortsfest gehalten ist.

6. Schalter nach Anspruch 5,
**dadurch gekennzeichnet,**
**dass** durch den im Ballon herrschenden Innendruck auf die Abdeckplatte (11) eine nach außen gerichtete Kraft aufgebracht ist, durch die die Abdeckplatte (11) dom- oder kuppelförmig ausgebildet ist.

7. Schalter nach Anspruch 4,
**dadurch gekennzeichnet,**
**dass** das elastisch verformbare Medium (16) als Silikonkissen ausgebildet ist, die zwischen der Abdeckplatte (11) und der Metallschicht (3) auf der Trägerplatte (2) angeordnet ist.

8. Schalter nach einem der vorgenannten Ansprüche,
**dadurch gekennzeichnet,**
**dass** auf der Trägerplatte (2) eine Vielzahl von Schaltfeldern (7) vorgesehen sind, deren Oberfläche aus der Metallschicht (3) bestehen, und dass die Schaltfelder (7) auf der Trägerplatte (2) durch die einstückig ausgebildete Abdeckplatte (11) nach außen verschlossen sind, und dass jedes der Schaltfeldder (7) zusammen mit der Abdeckplatte (11) bzw. von dem Metallüberzug (12) das eine Kapazitätsfeld (5) ausbildet.

9. Schalter einem der vorgenannten Ansprüche,
**dadurch gekennzeichnet,**
**dass** die Metallschicht (3) mittels einer elektrischen Leitung an einem integrierten Schaltkreis (4) angeschlossen ist.

10. Schalter nach einem der vorgenannten Ansprüche,
**dadurch gekennzeichnet,**
**dass** die Abdeckplatte (11) ganz oder bereichsweise, vorzugsweise im Bereich eines der Schaltfelder (7), elastisch verformbar ausgebildet ist.

11. Schalter nach einem der vorgenannten Ansprüche,
**dadurch gekennzeichnet,**
**dass** die Metallschicht (3) als kapazitiver Touchpad (3') ausgebildet ist.
